# EUROPEAN PATENT APPLICATION

(11) **EP 4 832 059 A1**
(43) Date of publication of application: **28.10.2026**
(21) Application number: 24905861.1
(22) Date of filing: 31.10.2024
(51) Int. Cl.: H01L 23/49, H01L 23/367, H01L 23/492, H01L 25/07

(54) **ELECTRONIC PACKAGING DEVICE AND POWER MODULE**

(30) Priority: 19.12.2023 CN 202311755263
(71) Applicant: Zhuzhou CRRC Times Semiconductor Co., Ltd., Zhuzhou, Hunan 412005 (CN)
(72) Inventor: SHI, Haiding, Zhuzhou, Hunan 412005 (CN); LI, Guisheng, Zhuzhou, Hunan 412005 (CN); CHANG, Guiqin, Zhuzhou, Hunan 412005 (CN); XIAO, Qiang, Zhuzhou, Hunan 412005 (CN); LUO, Haihui, Zhuzhou, Hunan 412005 (CN); SHAO, Yu, Zhuzhou, Hunan 412005 (CN); LIU, Yuanjian, Zhuzhou, Hunan 412005 (CN); HE, Xionghui, Zhuzhou, Hunan 412005 (CN); CHEN, Chao, Zhuzhou, Hunan 412005 (CN)
(74) Representative: Elzaburu S.L.P.
(86) International application number: PCT/CN2024/128867
(87) International publication number: WO 2025/130373

(57) **Abstract**

The present disclosure relates to the technical field of semiconductor packaging, and in particular, to an electronic package device and a power module. The disclosed electronic package device includes a liner plate for mounting of chips, a plastic package body wrapping around the liner plate, and a plurality of first terminals used to connect the liner plate to an external electric appliance, where each first terminal is at least partially embedded into the plastic package body, the first terminal is of a stepped structure with a step, and an end surface of the step of the stepped structure is flush with a molded top surface of the plastic package body to form a contact seal.

## Description

### Field of the Invention

The present disclosure relates to the technical field of semiconductor packaging, and in particular, to an electronic package device and a power module.

### Background of the Invention

With the rapid development of the fields of new energy power generation, electric vehicles, etc., the range of application of an IGBT power module to vehicles is increasingly wide. The power module is a core part for controlling an electric motor, and the performance, efficiency and power consumption of the power module are directly related to the performance and power consumption state of new energy vehicles.

Packaging forms of a power semiconductor module are divided into potting packaging and plastic packaging, where plastic packaging uses an epoxy resin to package the power module, which has the advantages of high production efficiency, high reliability and low water absorption, thereby receiving more and more attention.

At present, a manufacturing method for PIN needles used in plastic packaging is complicated and can be implemented only by undergoing processes such as trimming and forming. However, for separately welding the PIN needles on a liner plate and then plastically packaging the liner plate, there is a need for configuring a separate positioning structure for each PIN needle on a plastic package mold, which is difficult to achieve.

### Summary of the Invention

The present disclosure provides an electronic package device and a power module, in order to solve the problem that a separate positioning structure needs to be configured for each PIN needle on a plastic package mold during plastic packaging of an electronic package device in the related art.

In one aspect, the present disclosure provides an electronic package device. The electronic package device includes a liner plate for mounting of chips, a plastic package body wrapping around the liner plate, and a plurality of first terminals used to connect the liner plate to an external electric appliance, where each first terminal is at least partially embedded into the plastic package body, the first terminal is of a stepped structure with a step, and an end surface of the step of the stepped structure is flush with a molded top surface of the plastic package body to form a contact seal.

In an exemplary implementation, each first terminal includes a first connecting section and a second connecting section that are connected to each other, where the first connecting section is embedded into the plastic package body, one end of the first connecting section is connected to the liner plate, and the other end is flush with the top surface of the plastic package body. A radial dimension of the first connecting section is greater than a radial dimension of the second connecting section. The first connecting section and the second connecting section are coaxially connected to form the stepped structure, and the step of the stepped structure is located on an end surface of the first connecting section oriented toward one side of the second connecting section.

In an exemplary implementation, the first connecting section of the first terminal is a connector that is embedded into the plastic package body and connected to the liner plate. The second connecting section is a pin connected between the connector and the external electric appliance. The connector is of a sleeve structure, an outer diameter of an end of the pin used to be connected to the connector is greater than an inner hole diameter of the connector, and the pin is embedded into an inner hole of the connector through interference fit.

In an exemplary implementation, one end of the first connecting section forms a connecting portion for being connected to the liner plate, and the connecting portion is of a truncated pyramid structure formed by extending in a radial direction of the first connecting section. After plastic packaging, the connecting portion may be resisted and limited between the liner plate and the plastic package body.

In an exemplary implementation, each first terminal is an integrally-formed stepped PIN needle.

In an exemplary implementation, each first terminal is provided perpendicular to the liner plate.

In an exemplary implementation, the plurality of chips are provided and are connected to each other through copper bars; and/or, the chips are welded on the liner plate and are connected to the liner plate through the copper bars.

In an exemplary implementation, the electronic package device further includes a base plate for supporting and mounting the liner plate. The base plate includes a plate body for supporting and mounting the liner plate, and pin fins provided on the plate body. Heat generated by the chips may sequentially pass through the liner plate, the plate body and the pin fins, and undergo heat exchange with a coolant flowing through the pin fins.

In an exemplary implementation, one end of each pin fin is connected to the plate body, and the other end extends in a direction away from the plate body.

In an exemplary implementation, the plurality of pin fins are provided and are arranged on the plate body at intervals and in a uniform array.

In an exemplary implementation, the plurality of pin fins are provided and are arranged on the plate body at intervals and in a non-uniform array.

In an exemplary implementation, the electronic package device further includes: second terminals each being of a sheet structure, where one end of each second terminal is welded to the liner plate, and the other end extends outside the liner plate and the plastic package body to be connected to other electric appliance elements outside the electronic package device.

In an exemplary implementation, an extending portion of each second terminal is provided parallel to the liner plate.

In an exemplary implementation, a connecting hole is provided in the extending portion of the second terminal, and the second terminal is in threaded connection with an external component through the connecting hole.

In another aspect, the present disclosure provides a power module. The power module includes the foregoing electronic package device.

### Brief Description of the Drawings

The present disclosure will be described in more detail below with reference to the embodiments and in conjunction with the accompanying drawings.
FIG. 1 is a diagram of a three-phase full-bridge circuit according to an embodiment of the present disclosure;
FIG. 2 is a schematic structural diagram of an electronic package device according to an embodiment of the present disclosure;

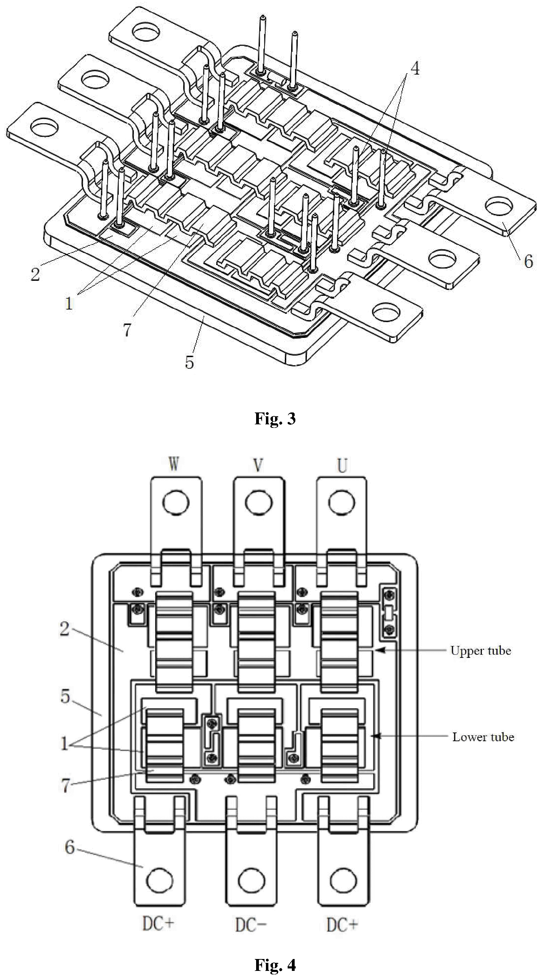

FIG. 3 is a schematic structural diagram of the electronic package device in FIG. 2 when plastic packaging is not performed;
FIG. 4 is a top view of the electronic package device in FIG. 3;

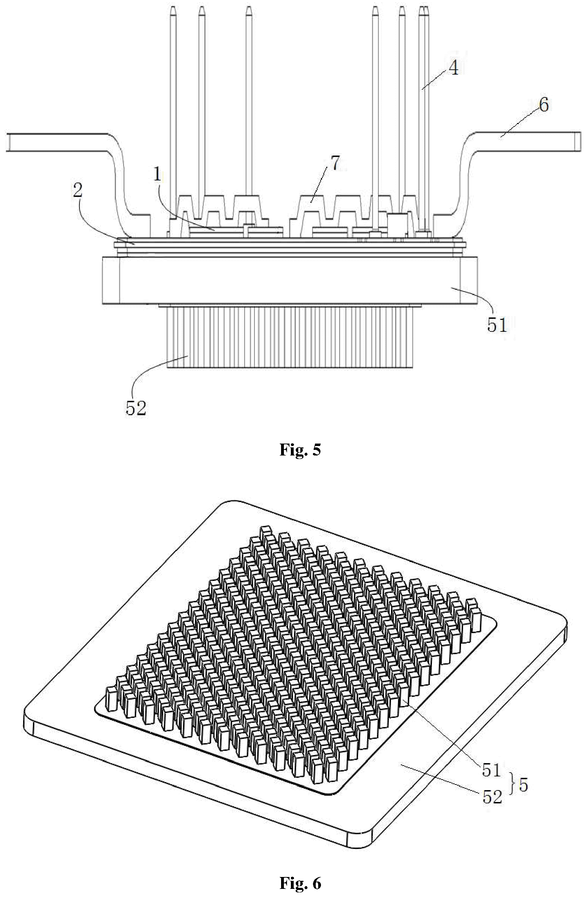

FIG. 5 is a side view of the electronic package device in FIG. 3;
FIG. 6 is an axonometric drawing of a base plate according to an embodiment of the present disclosure;

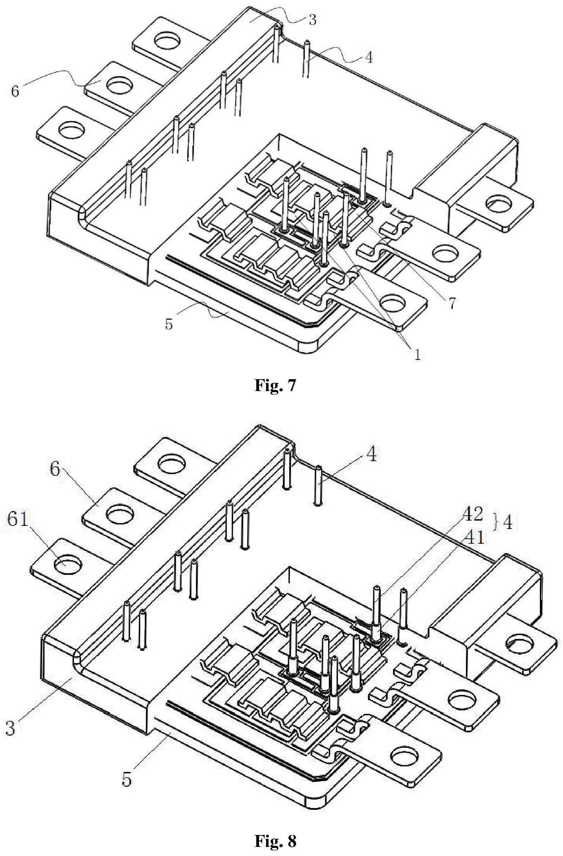

FIG. 7 is a schematic structural diagram of a displayable internal device, in which first terminals in a first implementation are displayed;
FIG. 8 is a schematic structural diagram of a displayable internal device, in which first terminals in a second implementation are displayed;

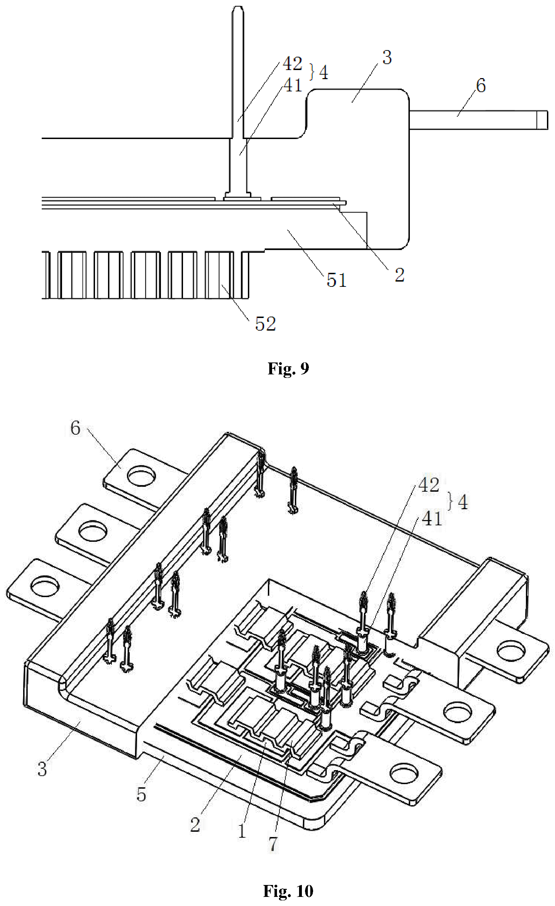

FIG. 9 is a schematic structural diagram of the first terminals in the second implementation;
FIG. 10 is a schematic structural diagram of a displayable internal device, in which first terminals in a third implementation are displayed;

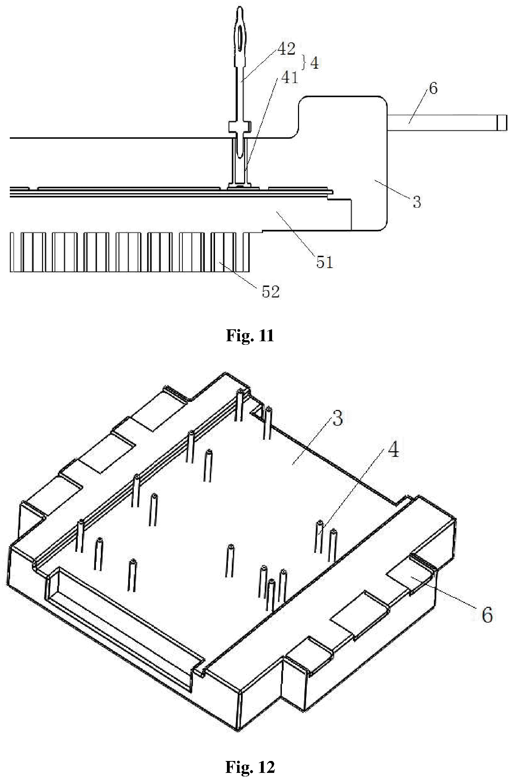

FIG. 11 is a schematic structural diagram of the first terminals in the third implementation;
FIG. 12 is a schematic structural diagram of an electronic package device in which second terminals in another implementation are mounted; and

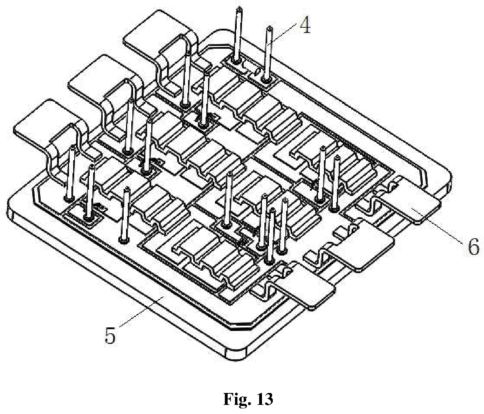

FIG. 13 is a schematic structural diagram of the electronic package device in FIG. 12 when plastic packaging is not performed.

Reference signs:
1. chip; 2. liner plate; 3. plastic package body;
4. first terminal; 5. first connecting section; 42. second connecting section;
5. base plate; 51. plate body; 52. pin fin;
6. second terminal; 61. connecting hole; and 7. copper bar.

### Detailed Description of the Embodiments

The present disclosure will be further illustrated below in conjunction with the accompanying drawings.

Main parts involved in this embodiment include chips 1, a liner plate 2, a base plate 5, first terminals 4, second terminals 6, and a plastic package body 3. The introduction of the main components is as follows.
(1) Liner plate 2: the liner plate 2 may be used for mounting and connecting of the chips 1 and mounting of the first terminals 4 and the second terminals 6, and the liner plate 2 is a direct bond copper (DBC or DCB) substrate and has a flat plate shape. The liner plate 2 may be made by using processes such as zirconia toughened alumina ceramics (ZTA) or an active metal bonding (AMB) technology. A ceramic insulating layer may be made of ceramic materials such as aluminum oxide, silicon nitride, or aluminum nitride, or other insulating materials. In order to enhance the thermal conduction capability or structural strength of the insulating layer, ceramics may be doped with oxides such as zirconium oxide (ZrO₂). Both upper and lower surfaces of the liner plate 2 are provided with conductive copper bonded layers to achieve electrical connection between electronic elements. The copper bonded layers of the liner plate 2 may be bare copper, or may be other clad layers of gold, nickel, silver, or the like that are clad on the surface of copper. The shape of the copper bonded layers may be adjusted according to actual needs and is not limited in this embodiment.
(2) Chips 1: the chips 1 are power elements mounted on the liner plate 2, and the chips 1 and the liner plate 2 are mounted and connected and are electrically connected to each other. For example, the chips 1 and the liner plate 2 may be mounted and connected through welding with a tin-based solder or through processes such as silver sintering and copper sintering. The chips 1 and the liner plate 2 may be electrically connected to each other by means of metal bonding wires or Cu Clips, or may be electrically connected through copper wires, aluminum wires, copper strips, or aluminum strips.

The plurality of chips 1 are provided and are arranged on the liner plate 2. The chips 1 may be connected to each other by means of bonding wires or Cu Clips, or may be connected to each other through copper wires, aluminum wires, copper strips, or aluminum strips. The arrangement manner of the plurality of chips 1 on the liner plate 2 may be that a chip of a grounded lower tube is close to a DC terminal, a chip of an upper tube connected to a positive electrode of a power supply is close to an AC terminal, and a dividing line between the upper tube and the lower tube is in a direction perpendicular to the line connecting the DC terminal to the AC terminal; or the dividing line between the upper tube and the lower tube is in a direction of the line connecting the DC terminal to the AC terminal.

The chips 1 may be FRDs/IGBTs, MOSFETs or SBDs/IGBTs that are made of materials such as a silicon-based material, silicon carbide (SiC), or gallium nitride (GaN), or may be other high-power chips 1.

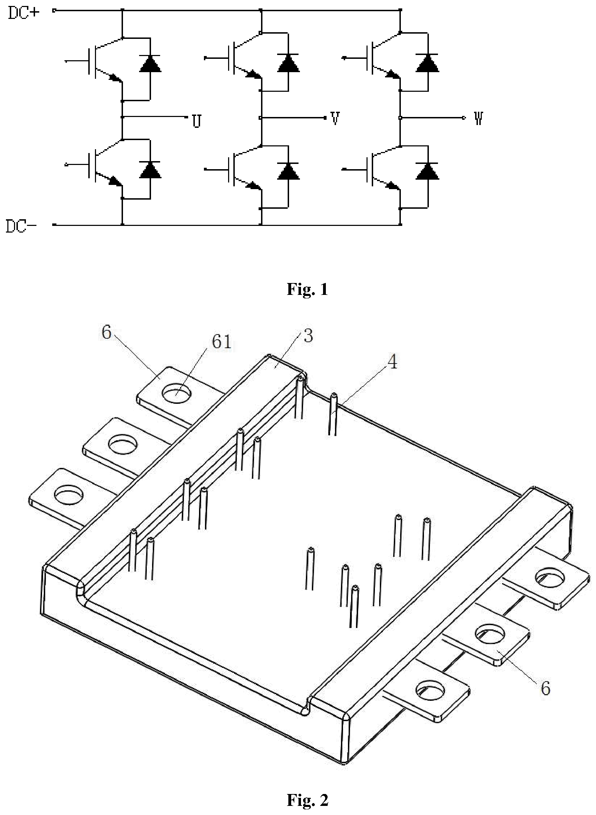

As shown in FIG. 1, in this embodiment, a modular circuit uses a three-phase full-bridge structure, uses a layout of a single liner plate 2, and uses six IGBT chips and six FRD chips, where each IGBT chip and the corresponding FRD chip are connected in anti-parallel to form a single tube, thereby forming a six-in-one three-phase full-bridge circuit topology. Certainly, the FRD chips in this embodiment may also be replaced with SiC chips.

(3) First terminals 4: the first terminals 4 are used to electrically connect the liner plate 2 to the outside. One end of each first terminal 4is connected to the liner plate 2 through welding with a solder, or through an ultrasonic welding process, and the other end extends in a direction perpendicular to the liner plate 2. The plurality of first terminals 4 are provided and are arranged on the liner plate 2 at intervals.

In this embodiment, each first terminal 4 is provided perpendicular to the liner plate 2, which can avoid terminals from extending out in a horizontal direction of the liner plate 2 in a traditional manner, thereby fully utilizing a vertical space of the liner plate 2, reducing the occupied area of the first terminals 4 on the liner plate 2, effectively increasing the utilization area of the liner plate 2, and reducing the horizontal area of the liner plate 2, thus reducing the overall size of an electronic package device, increasing the power density of the electronic package device, and reducing the plastic packaging cost. Moreover, parasitic parameters can also be reduced, thereby enhancing the controllability of the chips 1.

Each first terminal 4 is at least partially embedded into the plastic package body 3. The first terminal 4 is of a stepped structure with a step. An end surface of the step of the stepped structure is flush with a molded top surface of the plastic package body 3 to form a contact seal.

At present, a manufacturing method for PIN needles used in plastic packaging is complicated and can be implemented only by undergoing processes such as trimming and forming. However, for separately welding the PIN needles on a liner plate and then plastically packaging the liner plate, a separate positioning structure needs to be configured for each PIN needle on a plastic package mold, which is difficult to achieve. For the above-mentioned technical problems, in this embodiment, since the first terminal 4 is of the stepped structure with the step, the end surface of the step of the stepped structure is flush with the molded top surface of the plastic package body 3, and a first connecting section 41 is in direct contact with a wall surface of an upper mold cavity during transfer molding, there is no need for configuring the separate positioning structure for each PIN needle on the plastic package mold. Moreover, since the end surface of the step of the first terminal 4 and the plastic package body 3 form a contact seal therebetween during plastic packaging, the problem of an epoxy resin being prone to overflowing during transfer molding and plastic packaging is solved.

Each first terminal 4 includes a first connecting section 41 and a second connecting section 42 that are connected to each other, where the first connecting section 41 is embedded into the plastic package body 3, one end of the first connecting section 41 is connected to the liner plate 2, and the other end is flush with the top surface of the plastic package body 3. A radial dimension of the first connecting section 41 is greater than a radial dimension of the second connecting section 42. The first connecting section 41 and the second connecting section 42 are coaxially connected to form the stepped structure, and the step of the stepped structure is located on an end surface of the first connecting section 41 oriented toward one side of the second connecting section 42.

As a first implementation, each first terminal 4 is an integrally-formed linear PIN needle.

As a second implementation, each first terminal 4 is an integrally-formed PIN needle and is of a stepped "inverted-T" structure. The top of a step of the "inverted-T" structure is flush with the molded top surface of the plastic package body 3, thereby forming a contact seal area.

As a third implementation, the first connecting section 41 of the first terminal 4 is a connector that is embedded into the plastic package body 3 and connected to the liner plate 2. The second connecting section 42 is a pin connected between the connector and an external electric appliance. The connector is of a sleeve structure, an outer diameter of an end of the pin used to be connected to the connector is greater than an inner hole diameter of the connector, and the pin is embedded into an inner hole of the connector through interference fit. The pin is a crimped pin. After transfer molding, one end of the crimped pin is embedded into the inner hole of the connector through interference fit to form a PressFIT structure, thereby achieving welding-free press fitting.

In an exemplary implementation, one end of the first connecting section 41 forms a connecting portion for being connected to the liner plate 2, and the connecting portion is of a truncated pyramid structure formed by extending in a radial direction of the first connecting section 41. After plastic packaging, the connecting portion may be resisted and limited between the liner plate 2 and the plastic package body 3.

The first connecting section 41 is connected to the liner plate 2 through the connecting portion, and the connection portion can increase the contact area between the first connecting section 41 and the liner plate 2, such that connection is firmer. Moreover, the top wall of the connecting portion resists against the plastic package body 3 to prevent a sleeve from being separated from the plastic package body 3, such that connection is firmer. The other end of the first connecting section 41 is flush with the top surface of the plastic package body 3.

In this embodiment, the connector is welded to the liner plate 2 first, the top end of the connector is in direct contact with the wall surface of the upper mold cavity during transfer molding, and after the plastic package body 3 is formed through transfer molding, one end of a lead is embedded into the inner hole of the connector through interference fit, making the lead connected to the connector. Since the top end of the connector is in direct contact with the wall surface of the upper mold cavity, there is no need for configuring the separate positioning structure for each PIN needle on the plastic package mold, and the problem of the epoxy resin being prone to overflowing during transfer molding and plastic packaging is also solved.

In this embodiment, when the PIN needle is used as the first terminal 4, the shape and the connection manner can be reasonably and flexibly selected according to actual situations, and connection can be achieved by welding of the PIN needle to the liner plate 2 or by crimping of the connector and the crimped pin through interference fit to form the PressFIT structure, thereby achieving flexible configuration of an interface of the electronic package device to meet different interface application requirements of customers.

(4) Second terminals 6: each second terminal 6 is of a sheet structure. One end of the second terminal 6 is connected to the liner plate 2 through welding with a solder or through an ultrasonic welding process, and the other end of the second terminal 6 extends out of the liner plate 2 and the plastic package body 3 to be connected to other electric appliance elements outside the electronic package device. An extending portion of each second terminal 6 is provided parallel to the liner plate 2. As an implementation, a connecting hole 61 is provided in the extending portion of the second terminal 6, and the second terminal 6 may be in threaded connection with an external component through the connecting hole. As an implementation, the extending portion of the second terminal 6 is of a flat plate-shaped structure and may be welded to the external component through lasers.

Preferably, connection between the chips, between the chips 1 and the terminals, as well as between the chips 1 and the liner plate 2 is achieved through copper bars (DLB) 7, thereby not only reducing the heat resistance of the chips 1, but also reducing loop inductance, thus reducing the overall loss.

(5) Base plate 5: the base plate 5 plays an important role in overall heat dissipation of the electronic package device. The base plate 5 includes a plate body 51 and pin fins 52 provided on the plate body 51. Hat generated by the chips 1 sequentially passes through the liner plate 2, the plate body 51 and the pin fins 52, and undergoes heat exchange with a coolant flowing through the pin fins 52. The heat is transferred to the coolant, thereby reducing the temperature of the chips 1.

The plate body 51 serves to provide a mechanical support for the electronic package device in this embodiment and provide a mounting interface. The liner plate 2 is mounted on the plate body 51. The liner plate 2 and the base plate may be connected to each other through welding with a tin-based solder, or through sintering manners such as silver sintering and copper sintering, or through transient liquid-phase welding. A boss used to support the liner plate 2 and maintain the welding thickness between the liner plate 2 and the plate body 51 is circumferentially provided on the plate body 51. In an exemplary embodiment, the boss has a thickness of 0.05 mm to 0.3 mm. The size of the plate body 51 is adjusted according to the size of the circuit layout range. The overall size of the plate body 51 in this embodiment is not greater than 80 * 90 square millimeters.

The pin fins 52 are mainly used to dissipate heat. One end of Each pin fin 52 has is connected to the plate body 51, and the other end extends in a direction away from the plate body 51. The plurality of pin fins 52 are provided and are arranged on the plate body 51 at intervals. The plurality of pin fins 52 may be arranged in a uniform array, or may be arranged in a non-uniform array. The length of the pin fins 52 is slightly less than the depth of a radiator. In an exemplary implementation, the pin fins 52 have a length of 5.5 mm to 6.5 mm. The pin fins 52 have a shape of a column. The cross sections of the pin fins 52 may have a shape of a circle, an oval, a rhombus, a square, a caterpillar track, or a fin, or a combination of two or three thereof. Certainly, the cross sections of the pin fins 52 may have other shapes. The shape of the cross sections are not limited in this embodiment.

The pin fins 52 may be integrally formed with the plate body 51, or may be fixed to the plate body 51 by means of bonding, welding, etc. In this embodiment, the design solution involving the integrally-formed structure of the base plate 5 with pin fins 52 and the specially-shaped pin fins 52 can perform efficient heat dissipation and can be applied to low-power modules.

Materials of the plate body 51 and the pin fins 52 are highly thermally conductive materials, which may be bare copper, or may be other clad layers of nickel, silver, or the like that are clad on the surface of a copper layer.

(6) Plastic package body 3: the plastic package body 3 wraps around the liner plate 2 and the chips 1 on the liner plate 2, plays a role of insulating protection and sealing protection, provides a support for a circuit mounting interface, and has no impact on heat dissipation of the electronic package device. In most cases, the plastic package body 3 is made of a polymer material, e.g., an epoxy resin, for packaging. The use of the property of high-temperature resistance of the epoxy resin can support continuous work of the electronic package device at a higher temperature. Certainly, the plastic package body 3 may also be made of other materials that meet the requirements of pressure resistance and moisture resistance.

In this embodiment, the forming steps of the electronic package device are as follows. The chips 1, the first terminals 4 and the second terminals 6 are welded to the liner plate 2, respectively, and the liner plate 2 is welded to the base plate 5; electrical connection is performed on an electronic device; and then transfer molding and plastic packaging are performed to form the plastic package body 3.

In this embodiment, each first terminal 4 is provided perpendicular to the liner plate 2, thereby fully utilizing the vertical space of the liner plate 2, and reducing the horizontal area of the liner plate 2, thus increasing the power density of the electronic package device, and reducing the overall size of the electronic package device, such that the structure is more compact. Further, in this embodiment, the design solution involving the integrally-formed structure of the base plate 5 with the pin fins 52 and the specially-shaped pin fins 52 can improve the heat dissipating capacity of the electronic package device, making heat dissipation more efficient, thereby supporting continuous work of the electronic package device at a higher temperature and being applied to the low-power modules.

When the PIN needle is used as the first terminal 4, the shape and the connection manner can be reasonably and flexibly selected according to actual situations, and connection can be achieved by welding of the PIN needle to the liner plate 2 or by crimping of the connector and the crimped pin through interference fit to form the PressFIT structure.

The embodiments of the present disclosure use a three-phase full-bridge solution of the single liner plate 2, which can perform flexible adjustment on the circuit configuration according to application scenarios and is suitable for packaging of low-power and high-power density modules in automotive-grade application scenarios.

The electronic package device and the power module in the present disclosure have the following advantages.
1. At present, a manufacturing method for PIN needles used in plastic packaging is complicated and can be implemented only by undergoing processes such as trimming and forming. However, for separately welding the PIN needles on a liner plate and then plastically packaging the liner plate, there is a need for configuring a separate positioning structure for each PIN needle on a plastic package mold, which is difficult to achieve. For the above-mentioned technical problems, in this embodiment, since the first terminal is of the stepped structure with the step, the end surface of the step of the stepped structure is flush with the molded top surface of the plastic package body, and the first connecting section is in direct contact with the wall surface of the upper mold cavity during transfer molding, there is no need for configuring the separate positioning structure for each PIN needle on the plastic package mold. Moreover, since the end surface of the step of the first terminal and the plastic package body form the contact seal therebetween during plastic packaging, the problem of the epoxy resin being prone to overflowing during transfer molding and plastic packaging is solved.
2. In the present disclosure, each first terminal is provided perpendicular to the liner plate, thereby fully utilizing the vertical space of the liner plate, and reducing the horizontal area of the liner plate, thus increasing the power density of the electronic package device, and reducing the overall size of the electronic package device, such that the structure is more compact.
3. In the present disclosure, the design solution involving the integrally-formed structure of the base plate with pin fins and the specially-shaped pin fins can improve the heat dissipating capacity of the electronic package device, making heat dissipation more efficient, thereby supporting continuous work of the electronic package device at a higher temperature and being applied to the low-power modules.
4. In the present disclosure, connection between the chips, between the chips and the terminals, as well as between the chips and the liner plate is achieved through the copper bars (DLB), thereby not only reducing the heat resistance of the chips, but also reducing the loop inductance, thus reducing the overall loss.
5. The present disclosure uses the three-phase full-bridge solution of the single liner plate, which can perform flexible adjustment on the circuit configuration according to the application scenarios and is suitable for packaging of the low-power and high-power density modules in the automotive-grade application scenarios.

Although the present disclosure has been described with reference to the preferred embodiments, various modifications may be made thereto and components therein may be replaced with equivalents without departing from the scope of the present disclosure. In particular, various technical features mentioned in the various embodiments may be combined in any manner as long as there is no structural conflict. The present disclosure is not limited to the specific embodiments disclosed herein but includes all technical solutions falling within the scope of the claims.

## Claims

1. An electronic package device, wherein the electronic package device comprises a liner plate for mounting of chips, a plastic package body wrapping around the liner plate, and a plurality of first terminalsused to connect the liner plate to an external electric appliance,
each first terminal is at least partially embedded into the plastic package body, the first terminal is of a stepped structure with a step, and an end surface of the step of the stepped structure is flush with a molded top surface of the plastic package body to form a contact seal.

2. The electronic package device according to claim 1, wherein the first terminal comprises a first connecting section and a second connecting section that are connected to each other, wherein the first connecting section is embedded into the plastic package body, one end of the first connecting section is connected to the liner plate, and the other end is flush with the top surface of the plastic package body;
a radial dimension of the first connecting section is greater than a radial dimension of the second connecting section; and
the first connecting section and the second connecting section (42) are coaxially connected to form the stepped structure, and the step of the stepped structure is located on an end surface of the first connecting section oriented toward one side of the second connecting section.

3. The electronic package device according to claim 2, wherein the first connecting section of the first terminal is a connector that is embedded into the plastic package body and connected to the liner plate;
the second connecting section is a pin connected between the connector and the external electric appliance; and
the connector is of a sleeve structure, an outer diameter of an end of the pin used to be connected to the connector is greater than an inner hole diameter of the connector, and the pin is embedded into an inner hole of the connector through interference fit.

4. The electronic package device according to claim 2 or 3, wherein one end of the first connecting section forms a connecting portion for being connected to the liner plate, and the connecting portion is of a truncated pyramid structure formed by extending in a radial direction of the first connecting section; and
after plastic packaging, the connecting portion is resisted and limited between the liner plate and the plastic package body.

5. The electronic package device according to claim 1, wherein each first terminal is an integrally-formed stepped PIN needle.

6. The electronic package device according to claim 1, wherein each first terminal is provided perpendicular to the liner plate.

7. The electronic package device according to any one of claims 1 to 3, wherein the plurality of chips are provided and are connected to each other through copper bars; and/or,
the chips are welded on the liner plate and are connected to the liner plate through the copper bars.

8. The electronic package device according to any one of claims 1 to 3, wherein the electronic package device further comprises a base plate for supporting and mounting the liner plate; the base plate comprises a plate body for supporting and mounting the liner plate, and pin fins provided on the plate body; and
heat generated by the chips can sequentially pass through the liner plate, the plate body and the pin fins, and undergo heat exchange with a coolant flowing through the pin fins.

9. The electronic package device according to claim 8, wherein one end of each pin fin is connected to the plate body, and the other end extends in a direction away from the plate body.

10. The electronic package device according to claim 9, wherein the plurality of pin fins are provided and are arranged on the plate body at intervals and in a uniform array.

11. The electronic package device according to claim 9, wherein the plurality of pin fins are provided and are arranged on the plate body at intervals and in a non-uniform array.

12. The electronic package device according to any one of claims 1 to 3, wherein the electronic package device further comprises:
second terminals each being of a sheet structure, wherein one end of each second terminal is welded to the liner plate, and the other end extends outside the liner plate and the plastic package body to be connected to other electric appliance elements outside the electronic package device.

13. The electronic package device according to claim 12, wherein an extending portion of each second terminal is provided parallel to the liner plate.

14. The electronic package device according to claim 13, wherein a connecting hole is provided in the extending portion of the second terminal, and the second terminal is in threaded connection with an external component through the connecting hole.

15. A power module, comprising the electronic package device according to any one of claims 1 to 14.
